Europäisches Patentamt

European Patent Office

Office européen des brevets

(11) Publication number: **0 113 059**
**B1**

# (12) EUROPEAN PATENT SPECIFICATION

(45) Date of publication of patent specification: **12.11.86**

(51) Int. Cl.⁴: **H 01 L 21/28,** H 01 L 29/64

(21) Application number: **83112057.1**

(22) Date of filing: **01.12.83**

(54) **Method of forming a submicron width conductor and method of forming a field effect transistor incorporating such a conductor as a gate electrode.**

(30) Priority: **30.12.82 US 454915**

(43) Date of publication of application:
**11.07.84 Bulletin 84/28**

(45) Publication of the grant of the patent:
**12.11.86 Bulletin 86/46**

(84) Designated Contracting States:
**DE FR GB**

(56) References cited:
**EP-A-0 043 943**
**EP-A-0 057 254**
**US-A-4 280 854**

(73) Proprietor: **International Business Machines Corporation**
**Old Orchard Road**
**Armonk, N.Y. 10504 (US)**

(72) Inventor: **Jackson, Thomas Nelson**
**2 Feeney Road**
**Ossining New York 10562 (US)**

(74) Representative: **Hobbs, Francis John**
**IBM United Kingdom Limited Intellectual Property Department Hursley Park**
**Winchester Hampshire SO21 2JN (GB)**

Courier Press, Leamington Spa, England.

Description

This invention relates to a method of forming a submicron width conductor and a method of forming a field effect transistor incorporating such a conductor as a gate electrode.

As the technology in electronic circuit fabrication reaches the point where large quantities of devices and conductors are being placed together in a single functional unit, such as an integrated circuit chip and corresponding wiring supporting substrate, the ability to make electrodes and conductors of sizes that are smaller than a micron is acquiring increased importance. However, the fabrication of the very small conductors required for this technology usually requires elaborate processing techniques.

One technique currently receiving attention achieves small dimensions and precise positioning by defining a vertical positioning location or line on the planar surface of the device substrate, angularly depositing conductive material against the vertical face of the line to provide a thicker deposit against the face than on the horizontal and then removing the deposited material on the horizontal leaving the vertical portion of the deposited material. This technique achieves smaller dimensions than are directly attainable with the tolerances of the individual operations.

Very small dimensions have been achieved using the angular deposition technique applied under the developed overhang of a photoresist. This technique is described in the Journal of Vacuum Science and Technology, Vol. 19, No. 3, Sept./Oct. 1981, page 693. In this prior art technique, an undercut photoresist edge is provided with a metal film that is deposited at a low angle with respect to the substrate. The resulting metal film is thicker on the sidewall than on the horizontal surface. Thereafter, a metal etch can be used to remove the metal from the horizontal surfaces while leaving the metal on the photoresist sidewall. Lines with widths as small as 60 mm (600Å) are reported.

The angular deposition procedure however has certain disadvantages in that where the electrode being made has some length the line quality is dependent on the quality of the resist, usually a photoresist, edge against which the angular deposition took place. Defects may cause breaks. Further, if low resistance is required, then it is necessary to make the aspect ratio, that is the height with respect to the width, large and this in turn makes the now marginally supported line vulnerable to damage. Connections to such a small line are difficult.

The invention seeks to provide a method of forming a very narrow (submicron width) line which does not suffer from the aforementioned disadvantages.

A method of forming a very narrow conductor by depositing conductive material on a substantially vertical side wall of a layer of material supported on a substrate and subsequently removing unwanted portions of the deposited conductive material to leave a narrow conductor contiguous with the side wall is characterised, according to the invention, by the layer being a composite layer comprising dielectric material contiguous with the substrate and conductive material overlying the dielectric material.

How the invention can be carried out will now be described by way of example, with reference to the accompanying drawings, in which:—

Fig. 1 illustrates a composite layer comprising a metal on top of a dielectric terminating at a common edge;

Fig. 2 indicates the angle of deposit of conductive material against the common edge in the structure of Fig. 1;

Fig. 3 illustrates a conductor produced in accordance with the invention;

Fig. 4 represents one field effect transistor embodying a conductor formed in accordance with the invention; and

Fig. 5 represents another field effect transistor comprising a conductor formed in accordance with the invention.

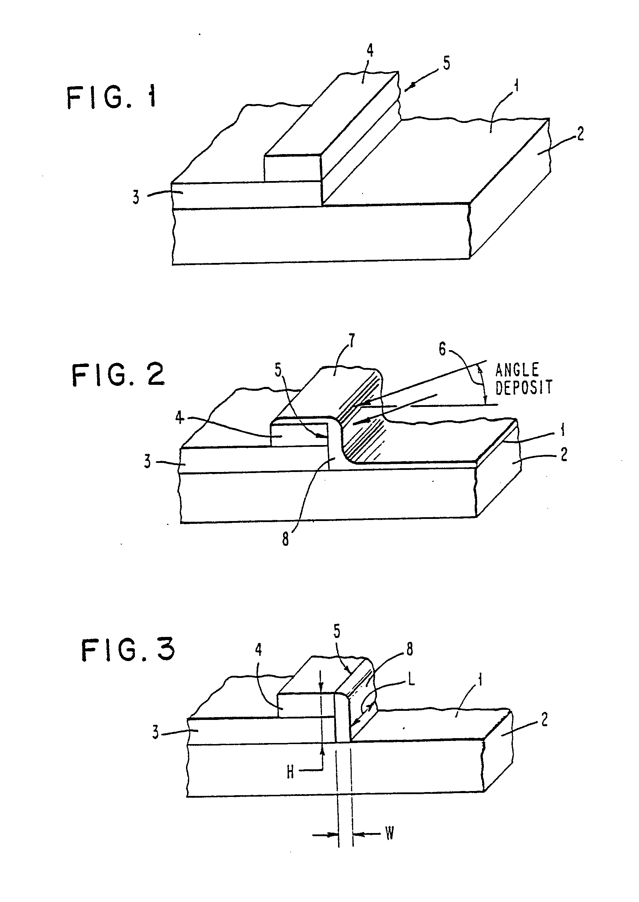

On a planar surface 1 (Fig. 1) of a substrate 2 there are placed a position defining dielectric member 3 at least partially covered by an electrode metal 4 both of which terminate at an electrode defining side wall 5 that is substantially vertical with respect to the planar surface 1. The side wall 5 can be positioned very precisely by such techniques as chemical and reactive ion etching. The electrode may be formed by deposition followed by anisotropic removal such as an etch or it may be preferably formed, referring to Fig. 2, by providing an angle 6 deposit of metal 7 against the edge 5. The metal 7, depending on the angle 6 chosen, will form a thicker portion 8 in the horizontal direction with respect to the planar surface 1 than along the plane of the surface 1. A removal operation, such as etching, will remove the metal 7 on the horizontal surfaces leaving an electrode of the portion 8 having a width determined by the thickness of the deposition along the edge 5, being supported along the height by the layers 3 and 4 and being contacted along its length by the metal layer 4. The submicron conductor is illustrated in Fig. 3 wherein the conductor itself is element 8 having a width (W) dimension governed by the location of the side wall 5 and the thickness of the deposit, the height (H) dimension being governed by the thickness of the layers 3 and 4 combined, both of which support the conductor 8 so that higher aspect ratios or in other words ratios of height to width are achievable and all along the length (L) dimension the conductor 8 is electrically and mechanically bonded to the metal layer 4 at the side wall 5 so that the electrical effect of discontinuities in the conductor 8 and imperfections in the dielectric 3 on the conductor 8 are minimized.

The conductor of the invention may be as small as less than 10 nm (100Å) in width and may reach 1 micron.

The conductor of the invention may be employed in any application wherein a very fine conductor that is precisely positioned is desired.

A particularly valuable application is serving as the gate electrode in a short channel field effect transistor. In this application, the electrode 8 in Fig. 3 would be positioned between source and drain electrodes, not shown, formed in the substrate 2. Since the gate 8 is contacted continuously by the layer 4 along the top at the edge 5, small defects which cause breaks will not cause electrical discontinuity. The height to width aspect ratio can be very large since the gate 8 is supported for the full H dimension by the layers 3 and 4 so that the W dimension is not affected by the need for mechanical stability. Since the gate 8 is shorted electrically by the metal 4, the gate resistance of the field effect transistor device would be low.

The size of the metal layer 4 in a gate application of the conductor 8 will increase gate capacitance so that excessive width in the direction away from the side wall 5 should be minimized. In order to enable one skilled in the art to have a starting point in accommodating this. gate capacitance, the following specifications are provided. Considering the substrate in Fig. 3 to be GaAs, the conductor 8 gate line to be 0.5 micrometers wide and the dielectric layer 3 separating the metal layer 4 from the substrate 2 to be 0.5 micrometers thick and the layer 4 to be 1.0 micrometers wide and 1.0 micrometers thick, the gate capacitance would increase about 15% over a gate wherein the width and height dimensions are the same or 0.5 micrometers each yet the gate resistance would be reduced about 600%.

Referring to Fig. 1, a submicron gate metal semiconductor field effect transistor (MESFET) may be formed using as a substrate 2 a crystal of gallium arsenide, GaAs, wherein a region of the substrate 2 shown is of device conductivity doped, for example, n-type to a concentration of the order of $10^{17}$ atoms per cc. A dielectric layer 3 of silicon dioxide, $SiO_2$, of the order of 0.5 micrometers thick covered by a layer 4 of aluminum of the order of 1.0 micrometers thick, both layers coterminating at a gate position defining side wall 5 located approximately midway on the substrate 2 between source and drain electrodes not shown. The layers 3 and 4 are positioned in accordance with standard deposition tolerances and a reactive ion etching operation is used to establish the location of the line 5 to within 0.5 micrometers.

Referring to Fig. 2, an angular deposition of a conductor such as the metal aluminum is directed to the side wall 5 with the horizontal angle 6 at about 20 degrees whereby a thin deposit 7 occurs on the layer 4 and on the surfaces 1 and 3 and a thicker deposit 8 occurs on the edge 5 of the layers 3 and 4 with the layer 4 electrically contacting the deposited metal 8 along the length thereof.

Referring next to Fig. 3, an eroding operation removes the material over the surface 1 a corresponding amount over the layer 4 and conductor 8. The conductor 8 now has the width or edge dimension (W) in electrical conduction influencing relationship to the FET channel in the substrate 2, is supported by the layers 3 and 4 for the full height and is electrically shorted throughout the length thereof by the layer 4 which also serves as a broad area external electrode. For self-aligned FET structures, the material of the conductor 8 would preferably be of a refractory nature such as Ti, W or alloys such as Ti/W, Ti, W, Si or TiN.

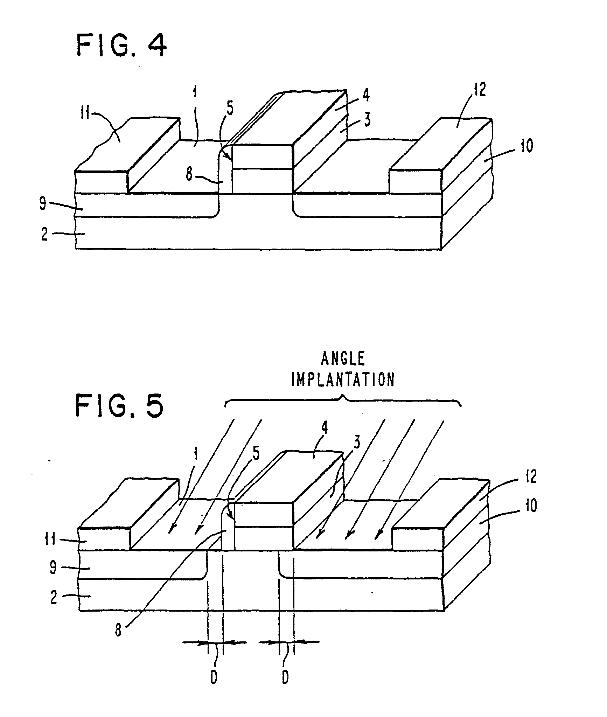

Referring next to Fig. 4, there is shown a field effect transistor (FET) employing the invention. The structure has the same reference numerals as in Figs. 1 to 3. In addition, in standard FET structural practice, the substrate 2 would have an n region adjacent the surface 1. An illustration of a standard FET structural practice is described in the 1981 IEEE International Solid-State Digest of Technical Papers, pages 218 and 219.

It should be noted that when as shown in Fig. 4, the electrode 8 is oriented towards the FET source 9, an ion implantation step can be used to form a self-aligned FET as shown with $n^+$ implanted regions 9 and 10 for the source and drain, respectively. These $n^+$ implanted regions are contacted subsequently by electrodes 11 and 12, respectively.

The source resistance of the FET of Fig. 4 while reduced to a minimum, has the advantage that the asymmetrical gate structure provided by the dielectric 3 covered by the metal 4 with electrode 8 operates to separate the gate from the drain $n^+$ implanted region 10 allowing larger gate-to-drain voltages and therefore greater power output in microwave applications.

Referring next to Fig. 5, there is shown another FET transistor employing the invention. In this structure, the source $n^+$ implanted region 9 is moved away from the gate 8 by a dimension D to accommodate imprecision or inaccuracy in the source 9 position. The imprecision can arise from ion implantation straggle or surface diffusion and can be a limit on short channel dimensions achievable in these devices. The angle implantation moves the drain region 10 a corresponding distance D under the dielectric 3 but with the asymmetrical conductor of the invention no problem is introduced.

## Claims

1. A method of forming a very narrow conductor (8) by depositing conductive material on a substantially vertical side wall (5) of a layer of material supported on a substrate (2) and subsequently removing unwanted portions of the deposited conductive material to leave a narrow conductor contiguous with the side wall characterised by the layer being a composite layer comprising dielectric material (3) contiguous with the substrate (2) and conductive material (4) overlying the dielectric material (3).

2. A method of forming a submicron width conductor (8) comprising an electrode (4) on a dielectric layer (3) disposed on a substrate (2), providing a common side wall (5) comprised by the dielectric layer and the electrode and disposed substantially perpendicular to the substrate, depositing conductive material (7) over the common side wall and removing unwanted portions of the deposited conductive material to leave a conductor (8) contiguous with the common side wall (5).

3. A method as claimed in claim 2, in which the conductive material is deposited at an acute angle to the top surface of the substrate so that a thicker deposit is formed on the common side wall than on the top surface of the substrate and the electrode and in which the conductive material deposited on the top surface of the substrate and the electrode is subsequently removed.

4. A method as claimed in claim 3, in which the conductive material is deposited at an angle of approximately 20° to the top surface of the substrate.

5. A method as claimed in any of claims 2 to 4, in which the substrate is of GaAs, the dielectric layer is of $SiO_2$ and both the electrode and the conductive material are of Al.

6. A method as claimed in any of claims 2 to 5, in which the submicron width conductor is a gate electrode disposed adjacent the source of a field effect transistor formed in the substrate.

7. A method of forming a self-aligned field effect transistor comprising the steps of:

applying a dielectric layer having a first thickness in contact with a substrate surface;

applying a conductive layer having a second thickness over the dielectric layer;

providing a common side wall comprised by both the dielectric and the conductive layers at a precise location on the substrate surface substantially perpendicular to the substrate surface;

depositing conductive material at an acute angle to the substrate surface whereby the conductive deposit exhibits a third thickness on the common side wall and a fourth thickness on the surface of the substrate and the conductive layer;

removing the conductive deposit at least to the extent of the fourth thickness on the substrate surface;

implanting conductivity impurities into the substrate surface to provide a source region and a drain region, the source region being separated from the conductive deposit on the common side wall and applying ohmic external contacts to each of the source and drain regions.

8. A method as claimed in claim 7, wherein the implantation step is performed at an angle.

**Patentansprüche**

1. Verfahren zur Ausbildung eines sehr schmalen Leiters (8) durch Abscheiden eines leitfähigen Materials auf einer im wesentlichen vertikalen Seitenwand (5) einer von einem Substrat (2) getragenen Materialschicht und nachfolgendes Entfernen ungewünschter Abschnitte des abgeschiedenen leitfähigen Materials derart, daß ein schmaler Leiter angrenzend an die Seitenwand stehenbleibt, dadurch gekennzeichnet, daß die Schicht eine zusammengesetzte Schicht ist, welche ein an das Substrat (2) angrenzendes dielektrisches Material (3) und ein über dem dielektrischen Material (3) liegendes leitfähiges Material (4) umfaßt.

2. Verfahren zur Ausbildung eines submikronbreiten Leiters (8), umfassend eine Elektrode (4) auf einer auf einem Substrat (2) angeordneten dielektrischen Schicht (3), das Vorsehen einer gemeinsamen Seitenwand (5), welche durch die dielektrische Schicht und die Elektrode aufgebaut und im wesentlichen senkrecht zum Substrat angeordnet ist, das Abscheiden von leitfähigen Material (7) auf der gemeinsamen Seitenwand und das Entfernen ungewünschter Abschnitte des abgeschiedenen leitfähigen Materials derart, daß ein an die gemeinsame Seitenwand (5) angrenzender Leiter (8) stehenbleibt.

3. Verfahren nach Anspruch 2, bei welchem das leitfähige Material unter einem spitzen Winkel zur oberen Fläche des Substrats abgescheiden wird, so daß auf der gemeinsamen Seitenwand eine dickere Abscheidung ausgebildet wird als auf der oberen Fläche des Substrats und der Elektrode, und bei welchem das auf der oberen Fläche des Substrats und der Elektrode abgeschiedene leitfähige Material nachfolgend entfernt wird.

4. Verfahren nach Anspruch 3, bei welchem das leitfähige Material unter einem Winkel von ungefähr 20° zur oberen Fläche des Substrats abgescheiden wird.

5. Verfahren nach irgendeinem der Ansprüche 2 bis 4, bei welchem das Substrat aus GaAs, die dielektrische Schicht aus $SiO_2$ und sowohl die Elektrode als auch das leitfähige Material aus Aluminium sind.

6. Verfahren nach irgendeinem der Ansprüche 2 bis 5, bei welchem der submikron-breite Leiter eine benachbart zur Source eines im Substrat ausgebildeten Feldeffekttransistors angeordnete Gate-Elektrode ist.

7. Verfahren zur Ausbildung eines selbstausgerichteten Feldeffekttransistors mit den Verfahrensschritten des

Aufbringes einer dielektrischen Schicht einer ersten Dicke in Berührung mit einer Substratfläche;

Aufbringens einer leitfähigen Schicht einer zweiten Dicke über der dielektrischen Schicht;

Vorsehens einer gemeinsamen Seitenwand, welche durch die dielektrische und die leitfähige Schicht aufgebaut ist, an einer genauen Stelle auf der Substratoberfläche im wesentlichen senkrecht zur Substratoberfläche;

Abscheidens von leitfähigem Material unter einem spitzen Winkel zur Substratoberfläche, wodurch die leitfähige Abscheidung auf der gemeinsamen Sietenwand eine dritte Dicke und auf der Oberfläche des Substrats und der leitfähigen Schicht eine vierte Dicke zeigt;

Entfernens der leitfähigen Abscheidung wenigstens im Ausmaß der vierten Dicke auf der Substratoberfläche;

Implantierens von Leitfähigkeitsfremdstoffen in die Substratsoberfläche zur Schaffung eines Source-Bereichs und eines Drain-Bereichs, wobi der Source-Bereich von der leitfähigen Abscheidung auf der gemeinsamen Seitenwand getrennt ist, und Aufbringens von ohmschen externen Kontakten auf den Source- und den Drain-Bereich.

8. Verfahren nach Anspruch 7, bei welchem der Implantationsschritt unter einem Winkel durchgeführt wird.

**Revendications**

1. Un procédé de formation d'un conducteur très étroit (8) par le dépôt d'une matière conductrice sur une paroi latérale pratiquement verticale (5) d'une couche de matière supportée par un substrat (12), et ensuite par l'enlèvement des parties non désirées de la matière conductrice déposée, pour laisser un conducteur étroit contigu à la paroi latérale, caractérisé en ce que la couche est une couche composite comprenant une matière diélectrique (3) contiguë au substrat (2) et une matière conductrice (4) recouvrant la matière diélectrique (3).

2. Un procédé de formation d'un conducteur (8) de largeur inférieure au micron, comprenant une électrode (4) sur une couche diélectrique (3) déposée sur un substrat (2), dans lequel on forme une paroi latérale commune (5) constituée par la couche diélectrique et l'électrode, et disposée de façon pratiquement perpendiculaire au substrat, on dépose une matière conductrice (7) sur la paroi latérale commune, et on enlève des parties non désirées de la matière conductrice déposée, pour laisser un conducteur (8) contigu à la paroi latérale commune (5).

3. Un procédé selon la revendication 2, dans lequel la matière conductrice est déposée sous un angle aigu par rapport à la surface supérieure du substrat, de façon qu'il se forme sur la paroi latérale commune un dépôt plus épais que sur la surface supérieure du substrat et sur l'électrode, et dans lequel on enlève ensuite la matière conductrice déposée sur la surface supérieure du substrat et sur l'électrode.

4. Un procédé selon la revendication 3, dans lequel la matière conductrice est déposée sous un angle d'environ 20° par rapport à la surface supérieure du substrat.

5. Un procédé selon l'une quelconque des revendications 2 à 4, dans lequel le substrat consiste en GaAs, la couche diélectrique consiste en $SiO_2$, et l'électrode ainsi que la matière conductrice consistent en Al.

6. Un procédé selon l'une quelconque des revendications 2 à 5, dans lequel le conducteur de largeur inférieure au micron est une électrode de grille qui est placée en position adjacente à la source d'un transistor à effet de champ formé dans le substrat.

7. Un procédé de formation d'un transistor à effet de champ auto-aligné, comprenant les opérations suivantes:

on applique en contact avec une surface d'un substrat une couche diélectrique ayant une première épaisseur;

on applique sur la couche diélectrique une couche conductrice ayant une seconde épaisseur;

on forme une paroi latérale commune constituée conjointement par la couche diélectrique et la couche conductrice, à un emplacement précis sur la surface du substrat, de façon qu'elle soit pratiquement perpendiculaire à la surface du substrat;

on dépose une matière conductrice sous un angle aigu par rapport à la surface du substrat, ce qui fait que le dépôt conducteur présente une troisième épaisseur sur la paroi latérale commune et une quatrième épaisseur sur la surface du substrat et sur la couche conductrice;

on enlève le dépôt conducteur, au moins sur une épaisseur correspondant à la quatrième épaisseur sur la surface du substrat;

on implante dans la surface du substrat des impuretés de détermination de conductivité, pour former une région de source et une région de drain, avec la région de source séparée du dépôt conducteur sur la paroi latérale commune, et on applique des contacts ohmiques externes sur chacune des régions de source et de drain.

8. Un procédé selon la revendication 7, dans lequel l'opération d'implantation est effectuée de manière oblique.

FIG. 1

FIG. 2

ANGLE
DEPOSIT

FIG. 3

# FIG. 4

# FIG. 5

ANGLE
IMPLANTATION